(19) Europäisches Patentamt

European Patent Office

Office européen des brevets

(11) EP 0 615 135 B1

(12) EUROPÄISCHE PATENTSCHRIFT

(45) Veröffentlichungstag und Bekanntmachung des Hinweises auf die Patenterteilung:
09.09.1998 Patentblatt 1998/37

(51) Int Cl.⁶: **G01R 33/48**

(21) Anmeldenummer: 94200529.9

(22) Anmeldetag: 02.03.1994

(54) **MR-Verfahren zur zwei- oder dreidimensionalen Abbildung eines Untersuchungsbereichs und Anordnung zur Durchführung des Verfahrens**

MR-method for imaging a two- or three dimensional examination region and apparatus for carrying out the method

Méthode de RM pour l'imagerie à deux au trois dimensions d'une région d'examen et dispositif pour la mise en oeuvre de la méthode

(84) Benannte Vertragsstaaten:
DE FR GB NL

(30) Priorität: 06.03.1993  DE 4307150
12.06.1993  DE 4319538

(43) Veröffentlichungstag der Anmeldung:
14.09.1994  Patentblatt 1994/37

(73) Patentinhaber:
• **Philips Patentverwaltung GmbH**
  **22335 Hamburg (DE)**
  Benannte Vertragsstaaten:
  **DE**
• **Koninklijke Philips Electronics N.V.**
  **5621 BA Eindhoven (NL)**
  Benannte Vertragsstaaten:
  **FR GB NL**

(72) Erfinder:
• **Kuhn, Michael Dr.-Ing.**
  **D-20097 Hamburg (DE)**
• **Rasche, Volker,**
  **D-20097 Hamburg (DE)**
• **Proksa, Roland,**
  **D-20097 Hamburg (DE)**

(74) Vertreter: **Hartmann, Heinrich, Dipl.-Ing. et al**
  **Philips Patentverwaltung GmbH,**
  **Röntgenstrasse 24**
  **22335 Hamburg (DE)**

(56) Entgegenhaltungen:
EP-A- 0 273 153          EP-A- 0 366 158
EP-A- 0 430 322          DE-A- 3 835 111
US-A- 4 761 613

**Beschreibung**

Die Erfindung betrifft ein MR-Verfahren zur zwei- oder dreidimensionalen Abbildung eines Untersuchungsbereichs, bei dem wiederholt ein Satz von Rohdaten gemessen wird, wobei aus jedem Satz ein Bild des Untersuchungsbereichs rekonstruierbar ist und wobei die Rohdaten eines Satzes mit unterschiedlichen Meßparametern aufgenommen werden und verschiedene Sätze mit den gleichen Meßparametern aufgenommene Rohdaten enthalten.

Meßparameter sind dabei Größe und/oder Richtung der magnetischen Gradientenfelder, die von der Anregung der Kernmagnetisierung in dem Untersuchungsbereich durch einen oder mehrere Hochfrequenzimpulse bis zur Erfassung des MR-Signals auf den Untersuchungsbereich einwirken bzw. eingewirkt haben. Das zeitliche Auflösungsvermögen eines durch ein MR-Verfahren (MR = Magnetresonanz) erzeugten MR-Bildes ist durch die Meßzeit bestimmt, innerhalb der der für ein MR-Bild erforderliche Satz von Rohdaten erfaßt werden kann. Dynamische Vorgänge im Untersuchungsbereich, wie z.B. die Ausbreitung eines Kontrastmittels, die sich in einem Zeitraum abspielen, der kleiner ist als die Meßzeit, können zwar auch noch ein MR-Bild beeinflussen, doch ist es mit dem bekannten Verfahren der eingangs genannten Art nicht möglich, anzugeben, wann innerhalb der Meßzeit diese Vorgänge aufgetreten sind. - Eine ähnliche Begrenzung gilt bei Schichtaufnahmen eines bewegten Patienten für die räumliche Auflösung.

Es ist daher Aufgabe der vorliegenden Erfindung, ein Verfahren mit verbesserter zeitlicher bzw. räumlicher Auflösung anzugeben sowie eine für die Durchführung dieses Verfahrens geeignete Anordnung.

Ausgehend von einem Verfahren der eingangs genannten Art wird diese Aufgabe dadurch gelöst, daß zur Erzeugung eines den Untersuchungsbereich in einem auswählbaren Zeitpunkt oder in einer auswählbaren Schicht darstellenden Bildes aus wenigstens zwei Sätzen von Rohdaten ein Satz von Hilfsdaten gebildet wird, daß die Hilfsdaten durch Interpolation aus den mit jeweils gleichen Meßparametern, jedoch zu unterschiedlichen Meßzeitpunkten bzw. für unterschiedliche Meß-Schichten ermittelten Rohdaten abgeleitet werden, daß das Gewicht, mit dem die Rohdaten in die Interpolation eingehen, umso größer ist, je kleiner der Abstand zwischen dem zugehörigen Meßzeitpunkt und dem auswählbaren Zeitpunkt bzw zwischen der Meß-Schicht und der ausgewählten Schicht ist, und daß das Bild des Untersuchungsbereichs aus dem Satz von Hilfsdaten rekonstruiert wird.

Bei der Erfindung werden die Bilder des Untersuchungsbereichs, also nicht - wie sonst allgemein üblich - unmittelbar aus den Rohdaten rekonstruiert, sondern aus den Hilfsdaten, die aus den Rohdaten durch eine Interpolation abgeleitet werden. In diese Interpolation gehen die Meßzeitpunkte der Rohdaten (bzw. die Lage der Meß-Schicht) sowie derjenige auswählbare Zeitpunkt (bzw. die Lage der ausgewählten Schicht) ein, für den bzw. die ein Bild des Untersuchungsbereichs rekonstruiert werden soll. Es läßt sich zeigen, daß das zeitliche Auflösungsvermögen dabei besser sein kann als der für die Erfassung eines Satzes von Rohdaten erforderlichen Meßzeit entspricht. Entsprechendes gilt auch für das räumliche Auflösungsvermögen in der Bewegungsrichtung eines bewegten Objektes.

Es sei an dieser Stelle darauf hingewiesen, daß aus der US-PS 4,710,717 ein MR-Verfahren zur Abbildung von periodisch pulsierenden Objekten, insbesondere dem menschlichen Herzen bekannt ist, bei dem mehrere Sätze von Rohdaten gemessen werden, wobei den Rohdaten mittels eines EKG-Signals die zeitliche Lage in bezug auf den Herzzyklus zugeordnet wird, währenddessen sie erfaßt werden. Die Sätze von Rohdaten werden allerdings nicht zeitlich nacheinander gemessen, sondern quasi gleichzeitig, indem bei jedem Herzzyklus mehrere MR-Sequenzen mit jeweils identischen magnetischen Gradientenfeldern auf den Untersuchungsbereich einwirken. Von Herzzyklus zu Herzzyklus werden die Phasenkodierungsgradienten geändert, so daß nach einer vom räumlichen Auflösungsvermögen abhängigen Zahl von Herzzyklen die Erfassung der Rohdatensätze komplettiert ist. Zur Rekonstruktion des Untersuchungsbereichs in einer bestimmten Phase des Herzzyklus werden die Rohdaten herangezogen, die in den einzelnen Herzzyklen während dieser Phase gemessen wurden. Wenn in einem Herzzyklus während der betreffenden Phase gerade keine Rohdaten angefallen sind, dann werden die gewünschten Rohdaten aus den Rohdaten derjenigen Sequenzen errechnet, die in dem betreffenden Herzzyklus vor und unmittelbar nach der gewünschten Phase gemessen wurden.

Das mit Hilfe dieser Daten rekonstruierte MR-Bild enthält somit Daten aus jedem Herzzyklus, so daß eine verbesserte zeitliche Auflösung nicht möglich ist. Daß einzelne Phasen der Herzaktion mit relativ geringer Bewegungsunschärfe abgebildet werden können, basiert darauf, daß sich die Kernmagnetisierungsverteilung im Untersuchungsbereich periodisch wiederholt. Ist dies nicht der Fall, wie beispielsweise bei einer Kontrastmitteluntersuchung (in der Phase, in der das Kontrastmittel in den Untersuchungsbereich hineinströmt), dann versagt das bekannte Verfahren.

Die Vorteile der Erfindung kommen dadurch voll zum Tragen, daß mehrere Sätze von Hilfsdaten erzeugt werden, die den Untersuchungsbereich zu unterschiedlichen - vorzugsweise äquidistanten - Zeitpunkten bzw. in unterschiedlichen Schichten darstellen, und daß die daraus rekonstruierten Bilder als Folge von Bildern wiedergegeben wird, insbesondere, wenn die Zahl dieser Bilder groß ist im Vergleich zur Zahl der Rohdatensätze.

Grundsätzlich kann die Erfindung mit jedem der bekannten MR-Verfahren ausgeführt werden, das eine genügend schnelle Akquisition eines Satzes von Rohdaten erlaubt. Eine bevorzugte Ausgestaltung der Erfindung sieht jedoch vor, daß der Untersuchungsbereich durch ein MR-Verfahren abgebildet wird, bei dem ein homogenes stationäres Magnetfeld auf einen Untersuchungsbereich einwirkt, daß zur Erzeugung eines ersten Satzes von Rohdaten zunächst eine erste Sequenz mit wenigstens einem Hochfrequenzimpuls auf den Untersuchungsbereich einwirkt, daß das dabei erzeugte MR-Signal in Anwesenheit eines magnetischen Gradientenfeldes mit in einer ersten Richtung verlaufendem Gradienten ausgelesen wird, daß der ersten Sequenz weitere gleichartige Sequenzen folgen, wobei von Sequenz zu Sequenz die Richtung des Gradienten variiert wird, bis alle Richtungen durchlaufen sind, daß ein erster Satz von Rohdaten durch eindimensionale Fouriertransformation über die bei diesen Sequenzen gewonnenen MR-Signale erzeugt wird und daß zum Erhalt wenigstens eines weiteren Satzes von Rohdaten die Sequenzenfolge wenigstens einmal wiederholt wird.

Das dieser Ausgestaltung zugrundeliegende, unter der Bezeichnung "Projektions-Rekonstruktionsmethode" bekannte MR-Verfahren hat die Eigenschaft, daß jede Sequenz Informationen über alle Raumfrequenzkomponenten des Untersuchungsbereichs liefert - im Gegensatz beispielsweise zum 2-DF-Verfahren, bei dem nur die Sequenz Informationen über die tiefen Raumfrequenzkomponenten liefert, bei der der Phasenkodierungsgradient den Wert Null hat.

In weiterer Ausgestaltung der Erfindung ist vorgesehen, daß ein zu untersuchendes Objekt während der Untersuchung relativ zum Untersuchungsbereich bewegt wird und daß während der Bewegung fortlaufend Sätze von Rohdaten gemessen werden, aus denen mindestens ein Satz von Hilfsdaten gebildet wird, aus denen jeweils ein MR-Bild rekonstruiert wird. Hierdurch ist es möglich, schon während des Einfahrens des (Patienten-) Körpers in den Untersuchungsbereich eine Folge von Querschnittsbildern des Körpers zu erzeugen, wobei das räumliche Auflösungsvermögen in der Bewegungsrichtung verbessert ist.

Eine MR-Anordnung zur Durchführung des erfindungsgemäßen Verfahrens ist versehen mit

- einem Magneten zur Erzeugung eines homogenen stationären Magnetfeldes,
- einer Gradientenspulenanordnung zur Erzeugung eines magnetischen Gradientenfeldes, dessen Gradient nach Größe und/oder Richtung veränderbar ist,
- wenigstens einer Hochfrequenzspulenanordnung zur Erzeugung von Hochfrequenzimpulsen bzw. zum Empfangen von MR-Signalen,
- Mitteln zum Erzeugen von Rohdaten aus den MR-Signalen,
- einer Steuereinheit zum Steuern der vorgenannten Mittel und Spulenanordnungen, derart, daß mehrere Sätze von Rohdaten gebildet werden,
- einer Interpolationseinheit zur Erzeugung von wenigstens einem Satz von Hilfsdaten aus jeweils zwei oder mehreren Sätzen von Rohdaten und
- einer Rekonstruktionseinheit zum Rekonstruieren eines MR-Bildes des Untersuchungsbereichs aus einem Satz von Hilfsdaten.

Die Erfindung wird nachstehend anhand der Zeichnung näher erläutert. Es zeigen:

Fig. 1     ein Gerät zur Durchführung des erfindungsgemäßen Verfahrens,

Fig. 2     den zeitlichen Verlauf einer Sequenz, mit der sich MR-Rohdaten für dieses Verfahren besonders günstig erfassen lassen,

Fig. 3     die bei dieser Sequenz gewonnenen Rohdaten in bezug auf den Untersuchungsbereich,

Fig. 4     den zeitlichen Ablauf des Untersuchungsverfahrens und

Fig. 5     ein Prinzipschaltbild der Anordnung nach Fig. 1.

Fig. 6     die räumliche Zuordnung der Meßschichten beim Vorschub eines Patienten in den Untersuchungsbereich.

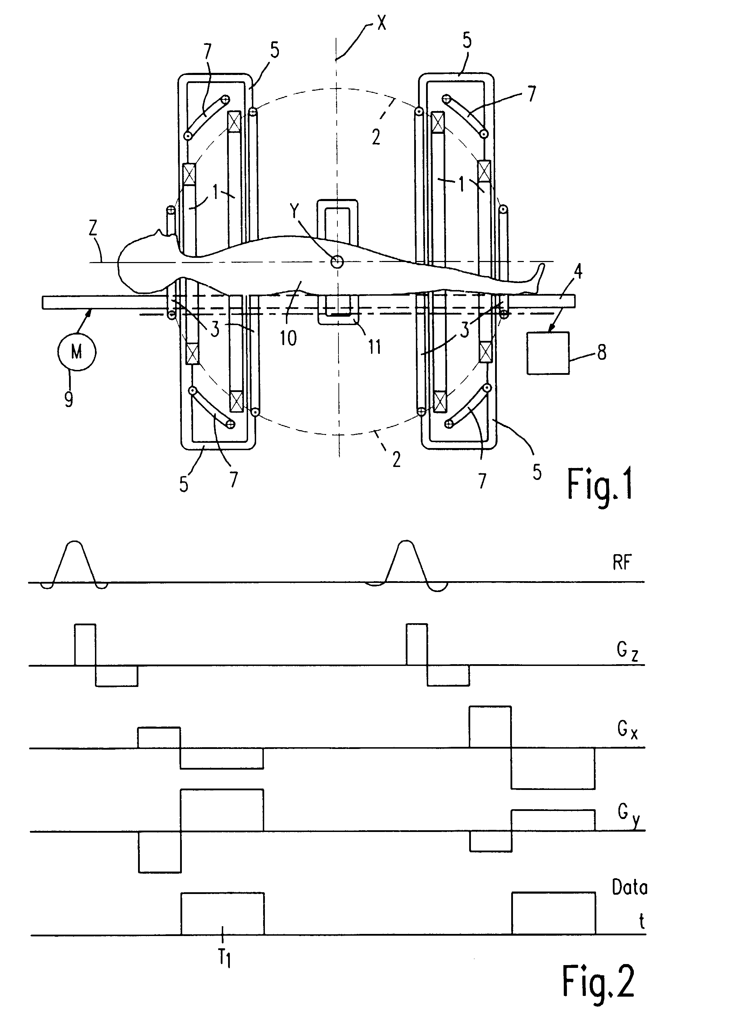

Das in Fig. 1 dargestellte Gerät ist ein MR-Gerät mit einer aus vier Spulen 1 bestehenden Anordnung zur Erzeugung eines homogenen stationären Magnetfeldes, das in der Größenordnung von einigen Zehntel Tesla bis einigen Tesla liegen kann. Die zur z-Achse konzentrisch angeordneten Spulen 1 können auf einer Kugelfläche 2 angeordnet sein. Im Innern dieser Spule befindet sich der zu untersuchende Patient 10 auf einer Tischplatte 4.

Zur Erzeugung eines in z-Richtung verlaufenden und sich in dieser Richtung linear ändernden Magnetfeldes (das im folgenden auch als Gradientenfeld bezeichnet wird) sind vier Spulen 3 auf der Kugeloberfläche 2 angeordnet. Weiterhin sind vier Spulen 7 vorgesehen, die ein ebenfalls in z-Richtung verlaufendes magnetisches Gradientenfeld erzeugen, dessen Gradient jedoch in x-Richtung (vertikal) verläuft. Ein in z-Richtung verlaufendes magnetisches Gradientenfeld mit einem Gradienten in y-Richtung (senkrecht zur Zeichenebene der Fig. 1) wird von vier Spulen 5 erzeugt, die mit den Spulen 7 identisch sein können, die jedoch diesen gegenüber um 90° räumlich versetzt angeordnet sind. Von diesen vier Spulen sind in Fig. 1 nur zwei dargestellt.

Da jede der drei Spulenanordnungen 3, 5 und 7 zur Erzeugung der magnetischen Gradientenfelder symmetrisch zur Kugeloberfläche angeordnet ist, ist die Feldstärke im Kugelzentrum nur durch das stationäre homogene Magnetfeld der Spule 1 bestimmt.

Weiterhin ist eine Hochfrequenzspule 11 vorgesehen, die ein im wesentlichen homogenes und senkrecht zur Richtung des stationären homogenen Magnetfeldes (d.h. senkrecht zur z-Richtung) verlaufendes hochfrequentes Magnetfeld erzeugt. Der Hochfrequenzspule wird während jedes Hochfrequenzimpulses ein hochfrequenter modulierter Strom von einem Hochfrequenzgenerator zugeführt. Die Hochfrequenzspule 11 kann ebenfalls zum Empfangen der im Untersuchungsbereich erzeugten Kernresonanzsignale eingesetzt werden. Es ist jedoch auch möglich, dafür eine gesonderte, in Fig. 1 nicht näher dargestellte Hochfrequenzempfangsspule zu verwenden.

Fig. 2 zeigt die zeitliche Lage verschiedener Signale bei zwei aufeinanderfolgenden Sequenzen, die für die Durchführung des erfindungsgemäßen Verfahrens besonders geeignet sind. In der ersten Zeile ist ein Hochfrequenzimpuls dargestellt, der in Verbindung mit einem magnetischen Gradientenfeld $G_z$ (zweite Zeile) als schichtselektiver Hochfrequenzimpuls wirksam ist. Durch diesen Hochfrequenzimpuls wird die Kernmagnetisierung in einer zur z-Achse senkrechten Schicht um einen geringen Flipwinkel (z.B. 5°) aus ihrer Ruhelage gekippt. Danach wirken zwei magnetische Gradientenfelder $G_x$ und $G_y$ gleichzeitig auf den Untersuchungsbereich ein, wobei beide Felder zu einem bestimmten Zeitpunkt die Richtung ihres Gradienten umkehren (dritte und vierte Zeile). Der zeitliche Verlauf ist dabei so gewählt, daß das zeitliche Integral über den Gradienten bis zur Polaritätsumkehr halb so groß ist, wie das zeitliche Integral von der Polaritätsumkehr bis zum Abschalten des magnetischen Gradientenfeldes. Grundsätzlich kann aber auch der vor der Polaritätsumkehr befindliche Teil des magnetischen Gradientenfeldes entfallen, so daß für die x- und y-Richtung gleichzeitig je ein im wesentlichen konstantes magnetisches Gradientenfeld auf den Untersuchungsbereich einwirkt.

Während dieses konstanten magnetischen Gradientenfeldes werden die im Untersuchungsbereich erzeugten MR-Signale verstärkt, in das Basisband transponiert und digitalisiert (fünfte Zeile von Fig. 2). Die Zahl der Abtastwerte, die dabei gewonnen werden, hängt vom gewünschten Auflösungsvermögen ab sowie von der Größe des Untersuchungsbereichs und beträgt z.B. 128 oder 256. Die Sequenz wird vielfach wiederholt, z. B. ebenfalls 128 oder 256 Mal, wobei von Sequenz zu Sequenz die Größe der Gradienten Gx und Gy gegensinnig zueinander geändert wird, so daß die Summe der Quadrate dieser Gradienten konstant bleibt. Das hat zur Folge, daß das aus der Überlagerung der magnetischen Gradientenfelder $G_x$ und $G_y$ resultierende magnetische Feld seine Richtung in der z-Ebene ändert, wobei der Betrag seines Gradienten konstant bleibt. Auf diese Weise wird die Richtung des aus der Überlagerung von $G_x$ und $G_y$ entstehenden Gradientenfeldes von Sequenz zu Sequenz geändert, bis ein Winkelbereich von wenigstens 180° durchlaufen ist (man kann das Verfahren auch so durchführen, daß erst nach Durchlaufen eines Winkelbereiches von 360° ein vollständiger Satz von Rohdaten erhalten wird). Die sogenannte Repetitionszeit (das ist der Zeitraum zwischen den beiden Hochfrequenzimpulsen) kann beispielsweise dabei 20 ms betragen, so daß die Zeit für die Akquisition der für ein Bild erforderlichen MR-Signale rund 5 Sekunden beträgt, wenn der Winkel von 180° bzw. 360° mit 256 Sequenzen erfaßt wird.

Die digitalisierten MR-Signale werden einer eindimensionalen Fouriertransformation unterzogen, wonach soviel transformierte Werte zur Verfügung stehen, wie vorher Abtastwerte vorhanden waren. Aus diesen transformierten Werten läßt sich ein Bild des Untersuchungsbereiches durch eine sogenannte gefilterte Rückprojektion rekonstruieren. - Das beschriebene MR-Verfahren mit Einschluß der Rekonstruktionsschritte ist dem Fachmann allgemein als sogenannte Projektions-Rekonstruktionsmethode bekannt.

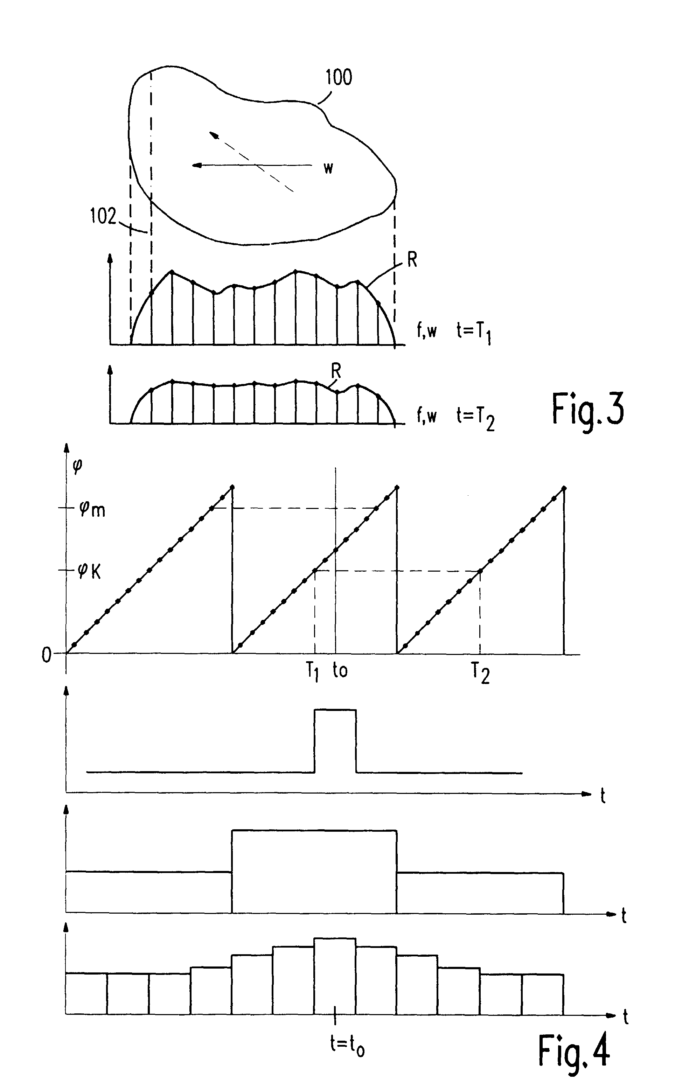

In Fig. 3 ist die durch die Sequenzen angeregte Schicht mit 100 bezeichnet und die Richtung, die das magnetische Gradientenfeld in dieser Schicht beispielsweise bei der ersten Sequenz hat, ist durch den Pfeil w angedeutet. Unterhalb des Untersuchungsbereichs ist die Kurve R eingezeichnet, die das Frequenzspektrum des in einer Sequenz aufgenommenen MR-Signals darstellt.

Dieses Frequenzspektrum ergibt sich bei der eindimensionalen Fouriertransformation des MR-Signals. Wenn man sich in Erinnerung ruft, daß bei dem Projektions-Rekonstruktionsverfahren die Frequenz der Kernspins sich linear mit dem Ort längs der Geraden w ändert, ergibt sich daraus, daß die Amplitude des Frequenzspektrums R die Projektion der Kernmagnetisierung auf die Gerade w, d.h. das Linienintegral der Kernmagnetisierungsdichte über einen zur Geraden w senkrechten Pfad innerhalb der Schicht, für einen bestimmten Ort darstellt. Somit ergibt sich diese Projektion für jeden Ort auf der Geraden w aus der Kurve R, wie durch die gestrichelte Gerade 102 für einen bestimmten Ort angedeutet ist.

Unter der Kurve R ist noch eine weitere Kurve dargestellt, die ebenfalls die Projektion der Kernmagnetisierung auf die Gerade w im Untersuchungsbereich darstellt - jedoch zu einem späteren Zeitpunkt, worauf in den Erläuterungen zu Fig. 4 noch näher eingegangen wird.

Fig. 4 zeigt im obersten Diagramm die zeitliche Abfolge bei der Erfassung mehrerer Sätze von Rohdaten, wobei als Ordinate die Gradientenrichtung und als Abszisse die Zeit aufgetragen ist. Jeder Punkt in diesem Diagramm entspricht der Erfassung eines MR-Signales. An sich wird das MR-Signal während eines endlichen Zeitraums erfaßt - vergl. Fig. 2, fünfte Zeile; da die Dauer dieses Zeitraums jedoch vernachlässigbar klein gegenüber der Zeit ist, die für die Erfassung eines ganzen Satzes von Rohdaten erforderlich ist, wird im folgenden davon ausgegangen, daß die bei der Erfassung eines einzigen MR-Signals aufgenommenen MR-Daten alle zum gleichen Zeitpunkt aufgenommen worden sind, der durch einen Punkt in dem Diagramm symbolisiert ist. Der zeitliche Abstand zwischen zwei aufeinanderfolgenden Punkten entspricht der Repetitionszeit der in Fig. 2 dargestellten Sequenz.

Wie das Diagramm zeigt, wird der gesamte Winkelbereich φ (von 0° bis 360°) gleichmäßig durch die aufeinanderfolgenden Sequenzen erfaßt. Nachdem auf diese Weise ein erster Satz von Rohdaten erfaßt worden ist, schließt sich unmittelbar ein weiterer Meßzeitraum an, in dem ein zweiter Satz von Rohdaten erfaßt wird, dem ein dritter Satz folgt usw. Gemäß dem Diagramm werden die Rohdaten eines Satzes mit (stufenweise) zunehmender Richtung des Gradienten durchlaufen; jedoch ist innerhalb eines Meßzeitraums jede beliebige andere Reihenfolge möglich, wobei diese Reihenfolge in dem zweiten und dritten Meßzeitraum aber beibehalten werden sollte.

Bei den bisher bekannten Projektions-Rekonstruktions-Verfahren werden Bilder des Untersuchungsbereiches jeweils aus dem während eines Meßzeitraums gemessenen Satzes von Rohdaten rekonstruiert. Bei der Erfindung wird demgegenüber zunächst ein Zeitpunkt ausgewählt, für den ein Bild des Untersuchungsbereichs rekonstruiert werden soll. Für diesen Zeitpunkt - z.B. $t_0$-werden Hilfsdaten durch Interpolation aus denjenigen Rohdaten (wenigstens) zweier Sätze von Rohdaten ermittelt, die jeweils dem gleichen Meßparameter zugeordnet sind, d.h. (bei der Projektions-Rekonstruktions-Methode) der gleichen Richtung $\varphi$ des Gradienten. Für die Richtung $\varphi_k$ beispielsweise errechnen sich die Hilfsdaten aus den zu den Zeitpunkten $t_1$ und $t_2$ ermittelten Rohdaten nach der Formel

$$H (\varphi_k, t_0) = g_k \cdot R (\varphi_k, t_1) + (1 - g_k) \cdot R (\varphi_k, t_2) \qquad (1)$$

Dabei steht H ($\varphi_k$, to) für die Hilfsdaten bei dem Meßparameter $\varphi_k$ und dem ausgewählten Zeitpunkt $t_0$, während R ($\varphi_k$, $t_1$) und R ($\varphi_k$, $t_2$) für die Rohdaten mit demselben Meßparameter $\varphi_k$ und den Meßzeitpunkten $t_1$ und $t_2$ stehen. $g_k$ ist ein dem Meßparameter $\varphi_k$ zugeordneter Interpolationsfaktor, der umso größer ist, je geringer der Betrag der Differenz $t_1 - t_0$ ist. Im einfachsten Fall gilt für $g_k$ eine lineare Abhängigkeit entsprechend der Gleichung

$$g_k = (t_2 - t_0) / (t_2 - t_1) \qquad (2)$$

Nach diesen Beziehungen können Hilfsdaten für alle anderen Meßparameter ermittelt werden, wobei in Gleichung (1) lediglich $\varphi_k$ durch den jeweiligen Meßparameter $\varphi$ zu ersetzen ist. Wenn dieser Wert $\varphi$ in dem Meßzeitraum, in dem $t_0$ liegt (hier also im zweiten Meßzeitraum), vor dem Zeitpunkt $t_0$ gegeben war (wie z.B. $\varphi_k$), dann müssen zur Interpolation die Rohdaten des betreffenden und des nachfolgenden Satzes von Rohdaten herangezogen werden. Wenn dagegen der Wert $\varphi$ erst nach $t_0$ gegeben war (wie z.B. $\varphi_m$), dann müssen die Rohdaten des betreffenden und des vorangehenden Satzes von Rohdaten zur Interpolation herangezogen werden. Grundsätzlich werden also die Rohdaten für den jeweiligen Meßparameter ($\varphi_m$ bzw. $\varphi_k$) herangezogen, die in dem geringsten zeitlichen Abstand zur Zeit $t_0$ gemessen wurden. Am Ende enthält der Hilfsdatensatz für den vorgegebenen Zeitpunkt $t_0$ genauso viele Hilfsdaten wie in einem Meßzeitraum Rohdaten erfaßt werden.

Wie Fig. 3 zeigt, werden im Zeitpunkt ($t_1$ oder $t_2$) nicht nur ein einziger Wert, sondern eine Anzahl von Rohdaten erfaßt, beispielsweise 128 oder 256. Um also die Werte gemäß Gleichung (1) und (2) zu berechnen, muß jeder Wert in der Kurve R für den Zeitpunkt t = $t_1$ mit dem entsprechenden (d.h. dem gleichen Ort zugeordneten) Wert in der Kurve t = $t_2$ interpoliert werden, so daß daraus ein Unter-Satz von Hilfsdaten ermittelt wird. Für diese Interpolationen gilt jeweils derselbe Interpolationsfaktor. Je dichter der Zeitpunkt $t_0$ dabei an der Zeit $t_1$ liegt, desto mehr entspricht der Verlauf der so ermittelten Hilfsdaten der Kurve R für t = $t_1$ und umgekehrt.

Wie bereits erwähnt wurde, kann man bei dem aus Fig. 2 ersichtlichen zeitlichen Verlauf der Sequenzen für das Projektions-Rekonstruktionsverfahren auch dann ein Bild des Untersuchungsbereiches rekonstruieren, wenn man nur einen Winkelbereich von 0 bis 180° erfaßt. In diesem Fall kann in jedem der Meßzeiträume die Gradientenrichtung $\varphi$ einen Winkelbereich von 0 bis 180° durchlaufen. Es ist aber auch möglich, im zweiten Meßzeitraum einen Winkelbereich zwischen 180 bis 360° und im dritten Meßzeitraum wieder von 0 bis 180° durchlaufen zu lassen usw. In diesem Fall gibt es zwar in keinem von zwei aufeinanderfolgend gemessenen Sätzen von Rohdaten solche, die mit derselben Gradientenrichtung gemessen wurden, jedoch gibt es welche, bei denen sich die Gradientenrichtung genau um 180° unterscheidet. In diesem Fall ändert sich die Frequenz des MR-Signals im Untersuchungsbereich als Funktion des Ortes genau in der umgekehrten Weise, so daß man bei der Interpolation den ersten Wert der einen Kurve und den letzten Wert der anderen Kurve heranziehen muß und für den zweiten Wert der einen Kurve den vorletzten Wert der anderen Kurve usw. Die Angabe "gleiche Meßparameter" im Hauptanspruch muß also in diesem Sinne weit ausgelegt werden.

Anhand des zweiten bis vierten Diagramms in Fig. 4 soll nachfolgend gezeigt werden, wie das zeitliche Auflösungsvermögen durch die Sequenz beeinflußt wird.

Im zweiten Diagramm von Fig. 4 ist die Zahl der Kerne, die von den mit der Hochfrequenzsendespule 11 erzeugten Hochfrequenzimpulsen beeinflußt werden können, als Funktion der Zeit t aufgetragen. Dabei ist angenommen, daß die Kerne gleichmäßig über den gesamten Untersuchungsbereich verteilt sind. Weiterhin ist angenommen, daß während der Erfassung des zweiten Rohdatensatzes die bis dahin konstante Zahl von Kernen (symmetrisch zum Zeitpunkt $t_0$) sprungartig erhöht wird (beispielsweise durch das Einströmen eines MR-Kontrastmittels in die abgebildete Schicht) und daß die Zahl Kerne danach wieder auf ihren ursprünglichen Wert zurückspringt.

Wenn man aus den in den drei Meßzyklen gewonnenen Rohdaten je ein MR-Bild rekonstruiert und diese drei Bilder zeitlich den zugehörigen Meßzeiträumen zuordnet, dann ergibt sich der im dritten Diagramm von Fig. 4 dargestellte zeitliche Verlauf der Intensität bzw. Helligkeit in den einzelnen Bildern. Das erste und das dritte Bild sind dabei von dem Sprung zur Zeit $t = t_0$ völlig unbeeinflußt, während im zweiten Bild die Helligkeit ansteigt. Da der Sprung nur während eines Zeitintervalls auftritt, das deutlich kleiner ist als der zweite Meßzeitraum, ist der Helligkeitssprung im dritten Diagramm im Verhältnis zur Helligkeit davor und danach nicht so ausgeprägt wie im zweiten Diagramm.

Wenn man stattdessen nach dem erfindungsgemäßen Verfahren Sätze von Hilfsdaten für eine Reihe von Zeitpunkten innerhalb der Meßzeiträume (beispielsweise jeweils vier Zeitpunkte pro Meßzeitraum) ermittelt und aus diesen Hilfsdaten je ein MR-Bild rekonstruiert, ergibt sich in diesen Bildern (die dann auch nur jeweils für 1/4 eines Meßzeitraums gelten) der im vierten Diagramm von Fig. 4 dargestellte zeitliche Verlauf der Intensität bzw. der Helligkeit. Man erkennt, daß auch hierbei der Intensitätssprung in dem für den Zeitpunkt $t = t_0$ rekonstruierten Bild nicht so ausgeprägt ist wie der Kontrastmittelsprung gemäß dem zweiten Diagramm. Man erkennt aber auch, daß die Intensität in den benachbarten Bildern stufenweise abnimmt bis auf den stationären Wert (d.h. der relativ kurze Sprung im zweiten Diagramm wird auch bei der Erfindung zeitlich stark verschliffen), jedoch kann man am vierten Diagramm gut erkennen, wann der Kontrastsprung aufgetreten ist, weil das für den Zeitpunkt $t = t_0$ rekonstruierte MR-Bild die größte Intensität zeigt. Hingegen kann man an den unmittelbar aus den Rohdaten erzeugten Bildern nicht erkennen, wann innerhalb des zweiten Meßzeitraums der Kontrastmittelsprung aufgetreten ist und wie lange er gedauert hat.

Es wäre nun zwar möglich, den unmittelbar aus den Rohdaten rekonstruierten Bildern ebenfalls einen Zeitpunkt zuzuordnen - beispielsweise die Mitte des zugehörigen Meßzeitraums - und aus diesen Bildern analog zum erfindungsgemäßen Verfahren Zwischenbilder zu rekonstruieren, doch würde sich bei diesen Zwischenbildern das Intensitätsmaximum immer bei denjenigen Bildern ergeben, die der Mitte des zweiten Meßzeitraums zugeordnet sind - unabhängig von der zeitlichen Lage des Kontrastmittelsprungs (zweites Diagramm) in bezug auf den zweiten Meßzeitraum.

Daß dabei die zeitliche Lage des Kontrastmittelsprungs mit Hilfe solcher Zwischenbilder nicht besser zu rekonstruieren ist, liegt daran, daß bei der Rekonstruktion eines Bildes die in den Rohdaten noch vorhandene Information über den Zeitpunkt verlorengeht. Bei der Rekonstruktion wird nämlich für jeden Bildpunkt des Bildes ein Wert rekonstruiert, zu dem eine Vielzahl von Rohdaten beiträgt, die zu unterschiedlichen Zeitpunkten gemessen worden sind. Deshalb kann man einem solchen Bildpunkt keinen Meßzeitpunkt zuordnen, der die zeitliche Lage genauer angibt als beispielsweise der die Mitte des Meßzeitraums kennzeichnende Zeitpunkt.

Daraus wird deutlich, daß sich die verbesserte zeitliche Auflösung nur ergibt, wenn die Hilfsdaten aus den Rohdaten ermittelt werden und nicht aus den nach der Bildrekonstruktion erzeugten Bilddaten. Rohdaten in diesem Sinne sind die in Fig. 3 dargestellten, durch eindimensionale Fouriertransformation erzeugten Daten (Kurven R). Als Rohdaten können aber auch die den zeitlichen Verlauf des MR-Signals wiedergebenden Digitalwerte benutzt werden, aus denen die Kurven R durch eindimensionale Fouriertransformation ermittelt werden. In diesem Fall müßte also der erste im Intervall um $t_1$ erfaßte Digitalwert mit dem ersten im Intervall um $t_2$ erfaßten Digitalwert, der zweite Digitalwert bei $t_1$ mit dem zweiten Digitalwert bei $t_2$ usw. interpoliert werden.

Bei dem vorstehend erläuterten Verfahren werden zur Erzeugung der Hilfsdaten jeweils nur die Rohdaten aus zwei Sätzen herangezogen. Die Interpolation kann aber auch mit den Rohdaten aus drei oder mehr Rohdaten - Sätzen erfolgen.

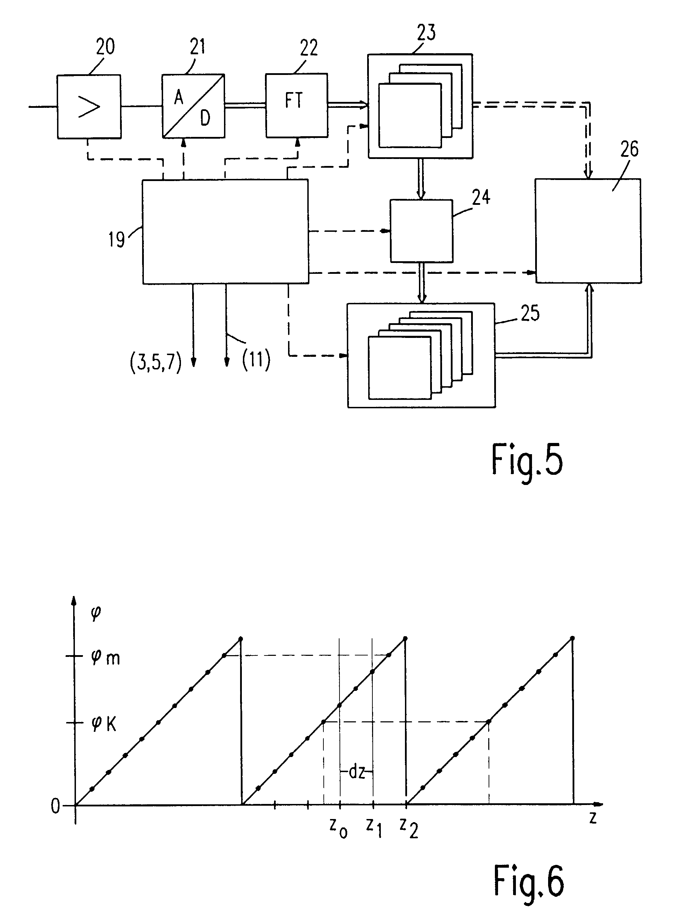

Aus den vorstehenden Erläuterungen ergibt sich für den Fachmann der in Fig. 5 dargestellte Aufbau des für die Durchführung des erfindungsgemäßen Verfahrens erforderlichen Signalverarbeitungsteils bei einem MR-Gerät gemäß Fig. 1. Danach werden die empfangenen MR-Signale von einer Einheit 20 verstärkt und in das Basisband transponiert. Das so erhaltene analoge Signal wird von einem Analog-Digital-Wandler 21 in eine Folge von Digitalwerten umgesetzt. Der Analog-Digital-Wandler 21 wird von einer Steuereinheit 19 so gesteuert, daß er nur während der Auslesephase (vgl. letzte Zeile von Fig. 2) digitale Datenworte erzeugt. Dem Analog-Digital-Wandler 21 ist eine Fouriertransformationseinheit 22 nachgeschaltet, die eine eindimensionale Fouriertransformation über die durch die Digitalisierung eines MR-Signals entstehende Folge von Abtastwerten durchführt, und zwar so schnell, daß die Fouriertransformation beendet ist, bevor das nächste MR-Signal empfangen wird.

Die auf diese Weise durch Fouriertransformation erzeugten Rohdaten werden in einen Speicher 23 geschrieben, dessen Speicherkapazität zur Aufnahme mehrerer Sätze von Rohdaten ausreicht. Eine Interpolationseinheit 24 bildet aus diesen Sätzen von Rohdaten in der angegebenen Weise Sätze von Hilfsdaten, die in einem Speicher 25 gespeichert werden, dessen Speicherkapazität zur Aufnahme einer größeren Anzahl von Sätzen von Hilfsdaten ausreicht. Diese Sätze von Hilfsdaten werden für verschiedene Zeitpunkte berechnet, deren gegenseitiger Abstand vorzugsweise klein ist im Vergleich zu der für die Aufnahme eines Satzes von Rohdaten erforderlichen Meßzeit. Aus den auf diese Weise ermittelten Sätzen von Rohdaten werden mit einer Rekonstruktionseinheit 26 in bekannter Weise MR-Bilder durch eine gefilterte Rückprojektion erzeugt und diese MR-Bilder gespeichert. Die MR-Bilder stellen den Untersuchungsbereich zu den vorgegebenen Zeitpunkten dar. Die Folge dieser aus den Hilfsdaten erzeugten MR-Bilder läßt die dynamischen Vorgänge im Untersuchungsbereich gut sichtbar werden. - Wahlweise können mit dieser Rekonstruktionseinheit in der üblichen Weise auch MR-Bilder unmittelbar aus den Rohdaten abgeleitet werden.

Die Einheiten 20 bis 26 werden von der Steuereinheit 19 gesteuert. Wie durch die nach unten gerichteten Pfeile angedeutet, gibt diese auch den zeitlichen Verlauf der Ströme in den Gradientenspulenanordnungen 3, 5 und 7 vor, sowie die Mittenfrequenz, die Bandbreite und die Umhüllende der mit der Hochfrequenzspule 11 erzeugten Hochfrequenzimpulse.

Die Speicher 23 und 25 sowie der in der Rekonstruktionseinheit 26 enthaltene, nicht näher dargestellte MR-Bild-Speicher können mit Hilfe eines einzigen Speichers mit genügend großer Kapazität realisiert werden. Die Fouriertransformationseinheit 22, die Interpolationseinheit 24 und die Rekonstruktionseinheit 26 können mittels eines geeigneten Datenprozessors realisiert werden.

Bei dem vorstehend beschriebenen Ausführungsbeispiel wurde das erfindungsgemäße Verfahren benutzt, um einen dynamischen Vorgang, wie eine Kontrastmittelinjektion mit verbesserter zeitlicher Auflösung darstellen zu können. Mit diesem Verfahren kann aber auch ein relativ zum Untersuchungsbereich bewegtes Objekt besser dargestellt werden, beispielsweise ein Patient beim Einfahren in den Untersuchungsbereich. Für diesen Einfahrvorgang liefert das erfindungsgemäße Verfahren eine Bildfolge mit in Einfahrrichtung verbesserter räumlicher Auflösung.

Zu diesem Zweck ist ein elektrischer Antrieb 9 für einen kontinuierlichen Vorschub der Tischplatte in ihrer Längsrichtung (in z-Richtung), vorzugsweise mit konstanter Geschwindigkeit, vorgesehen. Wenn der zeitliche Verlauf des Tischplattenvorschubes nicht konstant bzw. vorbekannt ist, muß mit dem Tischplattenvorschub ein Geber gekoppelt sein, der ein der Lage z der Tischplatte entsprechendes Signal liefert. Dieser Geber ist in Fig. 1 mit 8 bezeichnet.

Während des Vorschubs wirken mehrere Folgen von Sequenzen auf den Untersuchungsbereich ein, wobei jede Folge sich aus einer Anzahl von Sequenzen zusammensetzt, die den in Fig. 2 dargestellten zeitlichen Verlauf haben können. Durch die von einem in z-Richtung verlaufenden Gradientenfeld (2. Zeile) begleiteten Hochfrequenzimpulse (1. Zeile) werden zur z-Richtung senkrecht verlaufende Schichten angeregt. Die Schichten könnten grundsätzlich auch schräg zur z-Richtung verlaufen, jedoch stets unter einem von Null verschiedenen Winkel.

Anschließend werden, wie in der dritten und vierten Zeile von Fig. 2 dargestellt, magnetische Gradientenfelder $G_x$ und $G_y$ erzeugt. Das Amplitudenverhältnis von $G_x$ und $G_y$ wird von Sequenz zu Sequenz geändert, so daß das durch die Überlagerung von $G_x$ und $G_y$ gebildete magnetische Gradientenfeld seine Richtung $\varphi$ im

Raum von Sequenz zu Sequenz ändert. Obwohl die schichtselektiven Hochfrequenzimpulse die Kernmagnetisierung jeweils in einer im Zentrum des Untersuchungsbereichs liegenden Schicht anregen, die im folgenden auch als Meß-Schicht bezeichnet wird, ändert sich die Lage des Patienten bzw. der Tischplatte 4 relativ zu dieser Schicht infolge des Tischplattenvorschubes. Deshalb hängt jedes MR-Signal nicht nur von der Richtung des bei seiner Messung wirksamen magnetischen Gradientenfeldes ab. sondern auch von der relativen Lage z, die der Patient 10 bzw. die Tischplatte 4 relativ zur Meß-Schicht bzw. zum Zentrum des Gerätes einnimmt.

Fig. 6 zeigt demgemäß die Gradientenrichtung $\varphi$ als Funktion der Lage z bei der Fassung mehrerer Sätze von Rohdaten, wobei vorausgesetzt ist, daß bei jedem Rohdatensatz die Gradientenrichtung in Stufen vergrößert wird. Man erkennt den gleichen Verlauf in bezug auf z wie bei dem Diagramm nach Fig. 4 in bezug auf t, was darauf zurückzuführen ist, daß der Meß-Zeitpunkt, zu dem ein MR-Signal erfaßt wird und die relative Lage z der Schicht bei der Erfassung dieses MR-Signals über die Vorschubgeschwindigkeit miteinander verknüpft sind.

Infolgedessen kann analog zu den Erläuterungen in Verbindung mit Fig. 4 für jede beliebige Lage einer Schicht - z.B. $z_0$ - aus den Rohdatensätzen ein Satz von Hilfsdaten durch Interpolation abgeleitet werden, aus denen das Bild dieser Schicht rekonstruiert wird. Dies kann für andere Schichten mit der Lage $z_1$, $z_2$ usw. wiederholt werden, die voneinander den Abstand $d_z$ haben.

Gibt man diese Schichtbilder zeitlich nacheinander wieder (z.B. mit dem gleichen zeitlichen Abstand, in dem die Tischplatte 4 die Positionen $z_0$, $z_1$, $z_2$ usw. durchfährt), dann ergibt sich eine Bildfolge mit in z-Richtung verbessertem Auflösungsvermögen. Der Benutzer erhält auf diese Weise schon während des Einfahrens bzw. kurz danach eine einem Film ähnliche Bildfolge, in der der Patient Schicht für Schicht "durchfahren" wird, wodurch es ihm erleichtert wird, die für die nachfolgende MR-Untersuchung wichtigen Bereiche festzulegen.

Eine Variante des zuvor erläuterten Verfahrens besteht darin, den Patienten bzw. die Tischplatte 4 nicht zu verschieben und stattdessen die Lage der jeweils angeregten Schicht bezüglich des Patienten bzw. des Untersuchungsbereichs von Sequenz zu Sequenz zu variieren. Zu diesem Zweck muß die Mittenfrequenz der schichtselektiven Hochfrequenzimpulse (1. Zeile von Fig. 2) von Sequenz zu Sequenz geändert werden. Allerdings ist die Verschiebung der Schicht auf den Teil des Untersuchungsbereichs beschränkt, in dem das stationäre Magnetfeld noch genügend homogen ist.

Obwohl das in Fig. 2 und 3 dargestellte Projektions-Rekonstruktionsverfahren für die Anwendungen in Verbindung mit der Erfindung besonders geeignet ist, können auch andere MR-Verfahren benutzt werden, beispielsweise ein 2-DF-Verfahren oder ein 3-DF-Verfahren.

**Patentansprüche**

1. MR-Verfahren zur zwei- oder dreidimensionalen Abbildung eines Untersuchungsbereichs, bei dem wiederholt ein Satz von Rohdaten gemessen wird, wobei aus jedem Satz ein Bild des Untersuchungsbereichs rekonstruierbar ist und wobei die Rohdaten eines Satzes mit unterschiedlichen Meßparametern aufgenommen werden und verschiedene Sätze mit den gleichen Meßparametern aufgenommene Rohdaten enthalten, dadurch gekennzeichnet, daß zur Erzeugung eines den Untersuchungsbereich in einem auswählbaren Zeitpunkt ($t_0$) oder in einer auswählbaren Schicht darstellenden Bildes aus wenigstens zwei Sätzen von Rohdaten ($R(\varphi_k,t_1)$, $R(\varphi_k,t_2)$) ein Satz von Hilfsdaten ($H(\varphi_k,t_0)$) gebildet wird, daß die Hilfsdaten durch Interpolation aus den mit jeweils gleichen Meßparametern($\varphi_k$), jedoch zu unterschiedlichen Meßzeitpunkten ($t_1,t_2$) bzw. für unterschiedliche Meß-Schichten ermittelten Rohdaten abgeleitet werden, daß das Gewicht ($g_k$), mit dem die Rohdaten in die Interpolation eingehen, umso größer ist, je kleiner der Abstand zwischen dem zugehörigen Meßzeitpunkt und dem auswählbaren Zeitpunkt bzw zwischen der Meß-Schicht und der ausgewählten Schicht ist, und daß das Bild des Untersuchungsbereichs aus dem Satz von Hilfsdaten rekonstruiert wird.

2. MR-Verfahren nach Anspruch 1, dadurch gekennzeichnet, daß mehrere Sätze von Hilfsdaten erzeugt werden, die den Untersuchungsbereich zu unterschiedlichen - vorzugsweise äquidistanten Zeitpunkten darstellen, und daß die daraus rekonstruierten Bilder als Folge von Bildern wiedergegeben wird.

3. MR-Verfahren nach Anspruch 1 oder 2, dadurch gekennzeichnet, daß der Untersuchungsbereich durch ein MR-Verfahren abgebildet wird, bei dem ein homogenes stationäres Magnetfeld auf einen Untersuchungsbereich einwirkt, daß zur Erzeugung eines ersten Satzes von Rohdaten zunächst eine erste Sequenz mit wenigstens einem Hochfrequenzimpuls auf den Untersuchungsbereich einwirkt, daß das dabei erzeugte MR-Signal in Anwesenheit eines magnetischen Gradientenfeldes mit in einer ersten Richtung verlaufendem Gradienten ausgelesen wird, daß der ersten Sequenz weitere gleichartige Sequenzen folgen, wobei von Sequenz zu Sequenz die Richtung des Gradienten variiert wird, bis alle Richtungen durchlaufen sind, daß ein erster Satz von Rohdaten durch eindimensionale Fouriertransformation über das bei diesen Sequenzen gewonnene MR-Signal erzeugt wird und daß zum Erhalt wenigstens eines weiteren Satzes von Rohdaten die Sequenzenfolge wenigstens einmal wiederholt wird.

4. MR-Verfahren zum Erzeugen von MR-Bildern nach einem der Ansprüche 1 bis 3, dadurch gekennzeichnet, daß ein zu untersuchendes Objekt (10) während der Untersuchung relativ zum Untersuchungsbereich bewegt wird und daß während der Bewegung fortlaufend Sätze von Rohdaten gemessen werden, aus denen mindestens ein Satz von Hilfsdaten gebildet wird, aus denen jeweils ein MR-Bild rekonstruiert wird.

5. MR-Anordnung zur Durchführung des Verfahrens nach einem der vorhergehenden Ansprüche mit

- einem Magneten zur Erzeugung eines homogenen stationären Magnetfeldes,
- einer Gradientenspulenanordnung zur Erzeugung eines magnetischen Gradientenfeldes, dessen Gradient nach Größe und/oder Richtung veränderbar ist,
- wenigstens einer Hochfrequenzspulenanordnung zur Erzeugung von Hochfrequenzimpulsen bzw. zum Empfangen von MR-Signalen,
- Mitteln zum Erzeugen von Rohdaten aus den MR-Signalen,
- einer Steuereinheit zum Steuern der vorgenannten Mittel und Spulenanordnungen, derart, daß mehrere Sätze von Rohdaten gebildet werden,
- einer Interpolationseinheit zur Erzeugung von wenigstens einem Satz von Hilfsdaten aus jeweils zwei oder mehreren Sätzen von Rohdaten und
- einer Rekonstruktionseinheit zum Rekonstruieren eines MR-Bildes des Untersuchungsbereichs aus einem Satz von Hilfsdaten.

**Claims**

1. An MR method for the two-dimensional or three-dimensional imaging of an examination zone, in which a set of raw data is repeatedly measured and an image of the examination zone can be reconstructed from each set, in which the raw data of a set is acquired with different measurement parameters, and in which different sets contain raw data acquired with the same measurement parameters, characterized in that in order to produce an image representing the examination zone at a selectable instant ($t_0$) or in a selectable slice, a set of auxiliary data ($H(\varphi_k,t_0)$) is formed from at least two sets of raw data ($R(\varphi_k,t_1)$, $R(\varphi_k,t_2)$), the auxiliary data being derived by interpolation from the raw data acquired with the same measurement parameters ($\varphi_k$), but at different measurement instants ($t_1$, $t_2$), or derived for different measurement slices, that the weight

(g<sub>k</sub>) applied to the raw data entering the interpolation is greater as the distance in time between the associated measurement instant and the selectable instant, or between the measurement slice and the selected slice, is smaller, and that the image of the examination zone is reconstructed from the set of auxiliary data.

2. An MR method as claimed in Claim 1, <u>characterized in that</u> several sets of auxiliary data are generated, which sets represent the examination zone at different, preferably equidistant instants, and that the images reconstructed therefrom are displayed as a sequence of images.

3. An MR method as claimed in Claim 1 or 2, <u>characterized in that</u> the examination zone is imaged by way of an MR method in which a uniform, steady magnetic field acts on an examination zone, initially a first sequence which comprises at least one RF pulse acting on the examination zone in order to generate a first set of raw data, the MR signal thus generated being read in the presence of a magnetic gradient field having a gradient extending in a first direction, said first sequence being succeeded by further, similar sequences, the direction of the gradient being varied from one sequence to another until all directions have been traversed, a first set of raw data being produced by one-dimensional Fourier transformation over the MR signal acquired during these sequences, and the series of sequences being repeated at least once in order to obtain at least one further set of raw data.

4. An MR method for generating MR images as claimed in one of the Claims 1 to 3, <u>characterized in that</u> an object (10) to be examined is moved relative to the examination zone during the examination, sets of raw data being continuously measured during the movement, at least one set of auxiliary data being formed from said raw data, and a respective MR image being reconstructed from said auxiliary data.

5. An MR apparatus for carrying out the method as claimed in one of the preceding Claims, comprising

- a magnet for generating a uniform, steady magnetic field,
- a gradient coil system for generating a magnetic gradient field whose gradient can be varied in respect of magnitude and/or direction,
- at least one RF coil system for generating RF pulses or for receiving MR signals,
- means for generating raw data from the MR signals,
- a control unit for controlling said means and coil systems so that several sets of raw data are formed,
- an interpolation unit for generating at least one set of auxiliary data from each time two or more sets of raw data, and
- a reconstruction unit for reconstructing an MR image of the examination zone from a set of auxiliary data.

**Revendications**

1. Procédé de RM en vue de l'imagerie à deux ou trois dimensions d'une région d'examen, dans lequel une série de données brutes est mesurée à plusieurs reprises, une image de la région d'examen pouvant être reconstruite à partir de chaque série et les données brutes d'une série étant enregistrées avec différents paramètres de mesure et différentes séries contenant des données brutes enregistrées avec les mêmes paramètres de mesure,

caractérisé en ce qu'en vue de la production d'une image représentant la région d'examen à un moment ($t_0$) à sélectionner ou dans une couche à sélectionner, une série de données auxiliaires ($H(\varphi_k,t_0)$) est formée à partir d'au moins deux séries de données brutes ($R(\varphi_k,t_1)$, $R(\varphi_k, t_2)$), que les données auxiliaires sont déduites par interpolation des données brutes déterminées avec respectivement les mêmes paramètres de mesure ($\varphi_k$) mais à des moments de mesure ($t_1,t_2$) différents ou pour des couches de mesure différentes, que le poids ($g_k$) attribué aux données brutes dans l'interpolation est d'autant plus grand que l'intervalle entre le moment de mesure correspondant et le moment à sélectionner ou entre la couche de mesure et la couche sélectionnée est petit et que l'image de la zone d'examen est reconstruite à partir de la série de données auxiliaires.

2. Procédé de RM selon la revendication 1,

caractérisé en ce que plusieurs séries de données auxiliaires sont produites et représentent la région d'examen à différents moments - de préférence - équidistants et que les images reconstruites à partir de là sont reproduites comme une séquence d'images.

3. Procédé de RM selon l'une des revendications 1 ou 2,

caractérisé en ce que la région d'examen est reproduite par un procédé de RM dans lequel un champ magnétique stationnaire homogène agit sur une région d'examen, qu'en vue de la production d'une première série de données brutes, une première séquence avec au moins une impulsion à haute fréquence agit d'abord sur la région d'examen, que le signal de RM produit à cette occasion est lu en présence d'un champ à gradient magnétique avec un gradient s'étendant dans une première direction, que d'autres séquences similaires suivent la première séquence, la direction du gradient variant d'une séquence à l'autre jusqu'à ce que toutes les directions aient été traversées, qu'une première série de données brutes est produite par transformation de Fourier unidimensionnelle par l'intermédiaire du signal de RM obtenu dans ces séquences et que cette succession de séquences est répétée au moins une fois en vue d'obtenir au moins une série supplémentaire de données brutes.

4. Procédé de RM en vue de la production d'images RM selon l'une des revendications 1 à 3, caractérisé en ce qu'un objet (10) à examiner est déplacé pendant l'examen par rapport à la région d'examen et que, pendant le mouvement, des séries de données brutes sont mesurées en continu et, à partir de là, il est formé au moins une série de données auxiliaires à partir desquelles une image RM est respectivement reconstruite.

5. Dispositif de RM en vue de la mise en oeuvre du procédé selon l'une des revendications précédentes avec

   - un aimant pour la production d'un champ magnétique stationnaire homogène;
   - un agencement de bobine à gradient en vue de la production d'un champ à gradient magnétique dont le gradient peut varier en grandeur et/ou en direction;
   - au moins un agencement de bobine à haute fréquence en vue de la production d'impulsions à haute fréquence ou en vue de la réception de signaux de RM;
   - des moyens pour la production de données brutes à partir des signaux de RM;
   - une unité de commande en vue de la commande des moyens précités et des agencements de bobines de telle sorte que plusieurs séries de données brutes soient formées;
   - une unité d'interpolation en vue de la production d'au moins une série de données auxiliaires à partir de deux séries ou plus de données brutes, et
   - une unité de reconstruction en vue de la reconstruction d'une image RM de la région d'examen à partir d'une série de données auxiliaires.

Fig.1

Fig.2

100

102

w

R

f,w   t=T₁

R

f,w   t=T₂

Fig.3

φ

φm

φK

0

T₁  to

T₂

t

t

t=t₀

t

Fig.4

Fig.5

Fig.6